Europäisches Patentamt

European Patent Office

Office européen des brevets

(11) Publication number : **0 510 900 A2**

# (12) EUROPEAN PATENT APPLICATION

(21) Application number : **92303519.0**

(22) Date of filing : **21.04.92**

(51) Int. Cl.⁵ : **H01L 23/525, H01L 21/90, H01L 23/62, H01L 23/60**

(30) Priority : **26.04.91 US 691945**

(43) Date of publication of application :
**28.10.92 Bulletin 92/44**

(84) Designated Contracting States :
**DE FR GB**

(71) Applicant : **AMERICAN TELEPHONE AND TELEGRAPH COMPANY**
**550 Madison Avenue**
**New York, NY 10022 (US)**

(72) Inventor : **Dunlop, Alfred Earl**
**91 Hunterdn Blvd.**
**Murray Hill, New Jersey 07974 (US)**
Inventor : **Frye, Robert Charles**
**334B Carlton Ave.**
**Piscataway, New Jersey 08854 (US)**
Inventor : **Tai, King Lien**
**95 Highland Circle**
**Berkeley Heights, New Jersey 07922 (US)**

(74) Representative : **Watts, Christopher Malcolm Kelway, Dr. et al**
**AT&T (UK) LTD. AT&T Intellectual Property Division 5 Mornington Road**
**Woodford Green Essex IG8 OTU (GB)**

(54) **Wetting-based breakable links.**

(57)   A breakable link is based on the principles of wetting which occurs between one material, when it is in liquid form, as it is placed on a surface of another material. Specifically, the breakable link of this invention is created by depositing a conducting layer over a region that encompasses two pads that are wettable by the deposited conducting layer and over an insulating area between the pads that is much less wettable by the deposited conducting layer. The link is broken by raising the temperature of the deposited conducting layer above its melting point. When the conducting layer melts, the wetting action of the two pads in combination with the non-wetting action of the insulating area draws the molten solder away from the insulating area and onto the pads. The drawing away from the insulating area breaks the electrical contact between the two pads.

FIG. 2

EP 0 510 900 A2

## Background of the Invention

This invention relates to breakable links, or fuses, in an integrated circuit structure. More particularly, this invention relates to breakable links for MOS integrated circuits.

Integrated circuit MOS transistors are typically made with extremely thin oxide layers (electrical isolation) as part of the MOS transistor's gate structure. The desire for an oxide layer that is thin stems from the fact that the speed of an MOS transistor is inversely proportional to the thickness of the layer. However, the thin oxide layer presents a substantial practical problem. Those who handle MOS devices often carry relatively large electrostatic chargers on their person, and a transfer of those charges to the MOS transistor's gate can puncture through the oxide layer and destroy the devices. The same result can occur when the gate comes in contact with any other structure that has a charge thereon. This problem occurs only at the *input* of the MOS devices where the input impedance is high and the oxide layer is particularly thin.

This sensitivity to electrostatic charge is ameliorated in the MOS art by connecting an electrostatic discharge (ESD) circuit between the MOS gate and the actual, accessible, input of the IC. See, for example, "Principles of CMOS VLSI Design - A Systems Perspective", Wetse et al., Addison-Wesley, 1985, pp. 227-231. The problem with the use of an ESD circuit at each input of the MOS ICs is that the ESD circuit reduces the speed (i.e., frequency response) of the MOS circuit itself due to the impedances and capacitances that are introduced into the MOS circuit by the ESD circuit.

Whether these ESD circuits are indeed necessary at the inputs after the ICs have been installed in the larger circuits to which they belong (e.g. a circuit board) may be open to question. It is clear, however, that during testing and handling of the MOS ICs prior to installation, the ESD circuits are necessary. Stated in other words, while it is accepted that ESD circuits are necessary during the testing and handling phases of ICs, it is possible that the protection afforded by the ESD circuits is unnecessary and may be dispensed with (if it were possible) when the MOS ICs are finally installed in their destined circuit and their inputs are connected to low impedance drive circuits. It is clear, in any event, that at least in some circumstances it is, indeed, safe to dispense with the ESD circuits after testing and installation. One such circumstance is when the MOS IC is designed with a number of test pads that are used only during the testing phase. Those inputs are inaccessible to users after testing and installation and, therefore, there is no need to worry about electrostatic discharge at those pads. ESD circuit or circuits can also be dispensed with when an input or inputs are interconnected in a single assembly and internal connections between components are not electrically accessible from outside the assembly.

In a separate field of art, fusible and breakable links have been designed into circuits. See, for example, "An Architecture for Electrically Configurable Gate Arrays", Gamal et al., IEEE Journal of Solid-State Circuits, Vol. 24, No. 2, April 1989, pp. 394-398; and "An 11000-Fuse Electrically Erasable Programmable Logic Device (EEPLD) With an Extended Macrocell", Wahlstrom et al., IEEE Journal of Solid-State Circuits, Vol. 23, No. 4, August 1988, pp. 916-922. Such links, sometimes referred to as "fuses" or "antifuses", are typically used to permanently modify the structure and, hence, the behavior of the circuits. The use of such links is found in ROM applications, PAL applications, and applications where more than the necessary number of circuit modules are manufactured on the IC chip, and failed modules are permanently substituted in the circuit with operational modules. In such fuse and anti-fuse applications, specific links are placed into the "make" or "break" condition by the application of a very concentrated and directed beam of energy, such as a laser.

It is an object of this invention to create an MOS circuit structure that includes ESD circuits which can be excised from the circuit.

It is another object of this invention to create links that can be placed in the "break condition" by the use of undirected energy source.

It is still another object of this invention to create links that can be placed in the "break" condition by the general application of heat, which may be the heat applied to the MOS IC during the connection of the MOS IC chip to other elements of the overall circuit in which the MOS IC operates.

## Summary of the Invention

These and other objects of the invention are achieved with a breakable link that is based on the principles of wetting which occurs between one material, when it is in liquid form, as it is placed on a surface of another material. Specifically, the breakable link of this invention is created by depositing a conducting layer over a region that encompasses two pads that are wettable by the deposited conducting layer and over an insulating area between the pads that is much less wettable by the depositied conducting layer. The link is broken by raising the temperature of the deposited conducting layer above its melting point. When the conducting layer melts, the wetting action of the two pads in combination with the non-wetting action (actually, less wetting) of the insulating area draws the molten conducting layer away from the insulating area and onto the pads. The drawing away from the insulating area breaks the electrical contact between the two pads.

The breakable link of this invention is readily employed to create ESD circuits that can be disconnected following a testing phase or during assembly. In the structure that employs this breakable link, the MOS input that initially needs to be protected is terminated at a pad. An intermediate pad is placed in proximity to the input pad and is separated from the input pad by an electrically insulating material. An ESD circuit is manufactured within the MOS IC and is connected between the intermediate pad and a test pad. A conducting layer, such as solder, is evaporated to cover a region between the MOS input pad and the intermediate pad. The material of the input pad and the intermediate pad is such that molten conducting layer wets that material. On the other hand, the insulating material between the input pad and the intermediate pad is one which molten conducting layer does not readily wet.

After manufacture of the MOS IC, testing of the IC proceeds by applying signals to the test pad. When the IC is determined to be operational, it is installed into an IC carrier. The link formed during the manufacturing stage by the conducting layer evaporated between the input pad of the circuit, on the one side, and the circuit comprising the intermediate pad, the ESD circuit and the test pad, on the other side, is broken by raising the temperature of the conducting layer above its melting point. This can be accomplished by a general application of heat or by a directed application of heat. Breaking of the link isolates the MOS circuits input pad from the ESD circuit and the parasitic capacitances associated therewith.

## Brief Description of the Drawing

FIG. 1 is a diagram that depicts the use of an electrostatic discharge circuit;
FIG. 2 is a side view of a substrate, depicting the structure of breakable link 15;
FIG. 3 is a top view of the FIG. 2 substrate, depicting the shape of breakable link 15;
FIG. 4 shows the forming of beads over pads 26 and 27 when the link is broken; and
FIG. 5 illustrates the wetting action of soapy water on glass and mercury on glass.

## Detailed Description

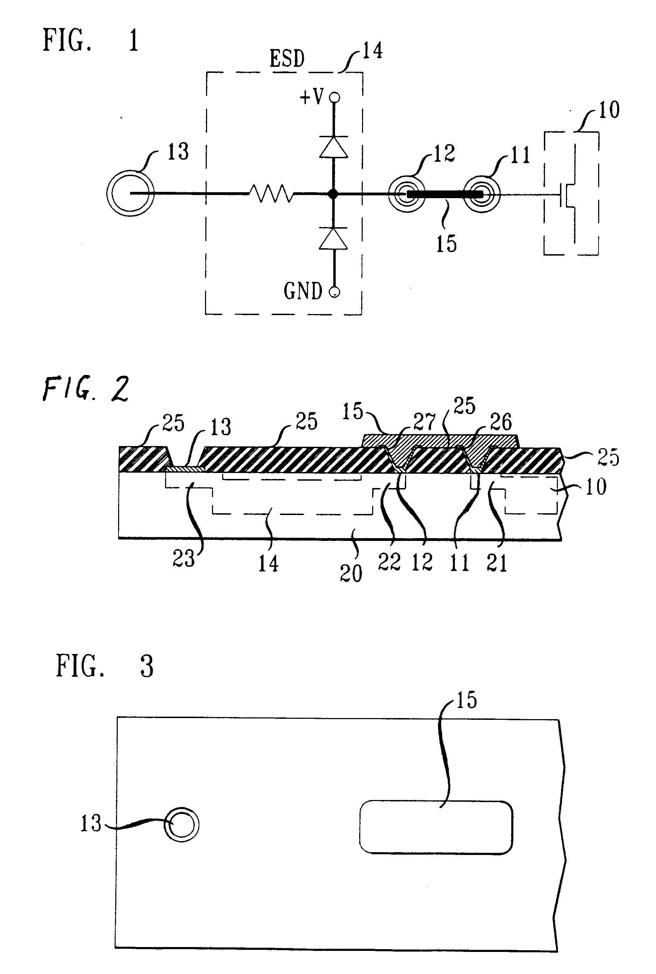

FIG. 1 presents a schematic diagram of a portion of an MOS circuit that conforms to the principles of this invention. Element 10 is an MOS transistor which is also an input of an MOS integrated circuit. The gate of transistor 10 is connected to pad 11. In proximity to pad 11, there is a pad 12 and in proximity to pad 12, there is testing probe pad 13. ESD circuit 14 is connected between pads 12 and 13. Circuit 14 may have different designs. In FIG. 1, it comprises a resistor connected between pad 13 and pad 12 and a pair of diodes. One diode is connected between a low voltage, -E, and pad 12, and the other diode is connected between pad 12 and a higher voltage, + V, that is used with the MOS circuitry. The direction of the diodes is arranged to block current from flowing from + V to -E. Stated in other words, the diodes are arranged to prevent the gate from becoming more negative than the lower voltage terminal of the MOS IC and from becoming more positive than the higher voltage terminal of the MOS IC.

In accordance with the principles of this invention, a breakable link 15 is constructed which electrically interconnects pads 11 and 12. The electrical connection is broken by the application of heat in accordance with the principles described below.

FIG. 2 presents a more physical view of the actual MOS integrated circuit depicted in FIG. 1. Substrate 20 is the substrate in which the MOS integrated circuit and the ESD circuit are constructed. The manner of constructing these circuits is unimportant to the concepts of this invention and, therefore, in FIG. 2 these circuits are merely shown as dotted blocks 10 and 14. Dotted block 10 includes a path 21 that connects (i.e., creates a permanent physical and electrical connection) to pad 11 and dotted block 14 includes paths 22 and 23 that connect to pads 12 and 13, respectively. Pads 11, 12 and 13 can be created on top of substrate 20 with standard deposition and etching techniques. The material of pads 11-13 must, of course, be electrically conducting. Typically, this material is metallic or contains metals. Also typically, the upper surface of pads 11, 12 and 13 is made of or contains materials that are wettable by the material that is placed on top of those pads to make a good electrical connection between those pads and circuitry outside the integrated circuit.

In areas not occupied by pads such as pads 11, 12 and 13 substrate 20 includes an insulating layer 25. The purpose of layer 25 is to insulate the lower structures and to create a surface that is much less wettable than the surface of pad 13 and pads 26 and 27 (described below). Layer 25 can be dispensed with if the material of substrate 20 meets that requirement. Otherwise, layer 25 needs to be made of a material that is less wettable, such as polyimide. Layer 25 may be created with conventional techniques by evaporating a blanketing layer and then etching it to expose pads 11, 12 and 13.

Although it is not absolutely necessary for the workings of this invention, to increase reliability of the connections to pads 11 and 12 FIG. 2 includes an electrically conducting pad 26 over pad 11 and over a small area of layer 25 in the neighborhood of pad 11, and an electrically conducting pad 27 over pad 12 and over a small area of layer 25 in the neighborhood of pad 12. In effect, pads 26 and 27 are extensions of pads 11 and 12, respectively. The purpose of pad extensions 26 and 27 is to increase the wettable surface in the neighborhood of pads 11 and 12, to form a larger wettable area to hold more of the meltable conducting layer, and to thereby increase the reliability of the electrical contact between pads 11 and 12 and the means for electrical access to those pads, as described below. Pad 26 does not have to fully span pad 11. It can cover a portion of pad 11, it can simply abut it, or even merely approach it. It may be noted, however, that when a separate insulating layer 25 is in fact deposited on substrate 20 and appropriately etched, pads 26 and 27 (when they cover pads 11 and 12, as depicted in FIG. 2) form a well. Preferably, when pads 26 and 27 are constructed to merely approach pads 11 and 12, they should still form a well. The material of pads 26 and 27 must be significantly more wettable than the insulator material of layer 25, and should preferably by one that adheres to, and provides a good electrical conduct with the material of pad 11.

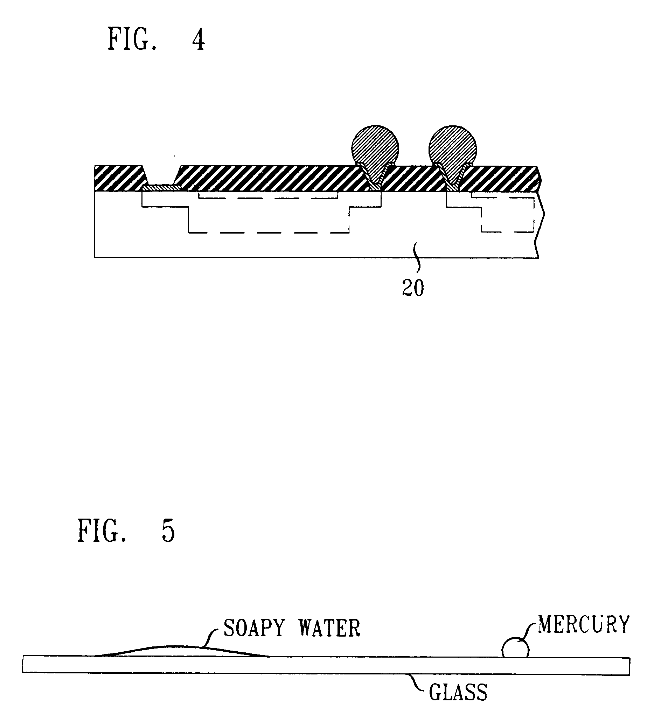

In accordance with the principles of this invention, an electrically conducting material is deposited to cover at least a portion of pads 26 and 27. In FIG. 2, it is depicted as a layer 15 which covers pads 26 and 27 and then some. It is only necessary that it form an electrical contact. In FIG. 1 it is depicted as the breakable link between pads 11 and 12, and in FIG. 3 (which is the top view of substrate 20 in correspondence with the side view of FIG. 2) link 15 is depicted as a rectangle (with rounded corners) that covers pads 26 and 27 and some of the insulating layer surrounding pads 26 and 27. Link 15 can be applied to the FIG. 2 circuit by conventional evaporation and etching techniques. That is, the electrically conducting material may be deposited to blanket the entire substrate and the rectangle created by etching the material away from the unwanted areas, or it may be selectively deposited.

In accordance with the principles of this invention, the electrically conducting material of layer 15 must have the characteristic that pads 26 and 27 are wettable by this material when it is in a liquid state and the insulator is significantly less wettable by this material when it is in a liquid state. Another characteristic of this material that is desirable (but not required) is that its melting point should be significantly lower than the melting point of the material of pads 26 and 27 and insulator 25. One good combination of materials is Cr or Cr-Cu alloy for the material of pads 26 and 27, a polyimide for the insulator, and solder for the breakable link layer 15.

When the temperature of the link 15 material is raised above its melting point, the material reshapes itself in accordance with the physical properties of wetting. That is, the combination of the wetting action of pad 26 and the non-wetting action of insulator 25 in a neighborhood of the pad draws the molten material of link 15 *toward* pad 26 and *away* from the insulating material in the neighborhood of pad 26. The drawing action forms a bead, or a "blob" over pad 26. Concurrently, the combination of the wetting action of pad 27 and the non-wetting action of insulator 25 in a neighborhood of the pad draws the molten material of link 15 *toward* pad 27 and *away* from the insulating material in the neighborhood of pad 27. When the neighborhood from whence pads 26 and 27 draw the material of link 15 extends beyond the area occupied by link 15 prior to melting, no link 15 material is left on insulator layer 25 once the material is melted and drawn by the "blobs" at pads 26 and 27, and the electrical connection between pads 26 and 27 is broken. This is depicted in FIG. 4. As an aside, in the context of this invention, the term "non-wetting" merely means that the material is significantly less "wetting" in comparison to another material that is more "wetting".

The size of the "neighborhood" referred to above is very difficult to define mathematically but quite easy to determine experimentally. This "neighborhood" is related to the wetting characteristics of the material making up link 15, pads 26 and 27, and layer 25. It is also related to the surface roughness of the pads and of layer 25, and to the volume of the material making up link 15. Although the phenomena of wetting is quite complex, most people have an intuitive feeling of what is meant by "wetting". For example, most would agree that mercury does not wet glass but soapy water does.

In more formal terms, wetting is associated with the surface energy of the materials involved. In a nutshell, a material having low surface energy, when it is in liquid form, wets material having a higher surface energy. The subject of wetting is more rigorously discussed in "Physical Chemistry of Surfaces" by Arthur W. Adamson, John Wiley & Sons, Inc., 1976, pp. 439-463.

In less formal terms, wetting is associated with the energy that creates the force which results in surface tension in the liquid. In the absence of gravity, surface tension causes a liquid to assume the shape of sphere. Viewed in this manner, wetting may be considered as something that controls the size of the area (footprint) that a liquid drop of a given volume would make when it is placed (with gravity present) on top of a solid material. On glass, for a given volume mercury makes a small footprint, whereas soapy water makes a large footprint. The angle that the soapy water makes with the glass is close to zero, while the angle that the mercury makes with the glass is substantially larger. This is illustrated in FIG. 5.

The "footprint" aspect of wetting as discussed above assumes that the solid surface that is being wetted is large. Another question arises when a small pad that is highly wettable by a liquid A abuts a surface that is much less wettable (for example, molten solder, on a fiberglass circuit board, with a small copper pad thereon). When a small amount of liquid A is placed on the pad, it spreads to the edges of the pad and forms a "blob" with a footprint that is coextensive with the pad. The angle that the liquid makes with the surface of the pad is somewhat larger than it would have been had the pad surface been very large. As additional amounts of liquid A are added to the pad, the "blob" increases in volume, its height increases, and the angle that the liquid makes with the pad surface also increases. As still additional amounts of liquid A are added, the angle reaches the angle that a "blob" of liquid A would make with the abutting (less wettable) surface if that liquid were on that surface. At that point, the pad can no longer support the "blob", and the "blob" spreads beyond the edges of the pad and onto the less wettable surface. Conversely, when a thin layer of liquid A is somehow deposited over the pad and over a small region of the less wettable surface around the pad, the liquid is drawn toward the pad and away from the less wettable surface to a point where a "blob" is created on the pad and no liquid is found on the less wettable surface. However, this condition results only when the total volume of liquid originally applied to the surface is less than the volume of a "blob" that can be supported by the pad. One can say that the pad gathers the liquid from a surrounding "neighborhood". The maximum area of that "neighborhood" is a function of the deposited volume of the liquid and of the volume of the "blob" that is supportable by the pad.

With this concept of a "neighborhood" in mind, the volume of the material of link 15 that is deposited (which is the area of rectangle 15 in FIG. 3 and the thickness of layer 15 in FIG. 2) should be such that pads 26 and 27 can draw essentially all of the material of the link into two "blobs" that are supported by pads 26 and 27. For a given amount of link 15 material, the separation between pads 26 and 27 should be as large as possible to ensure that the electrical connection between the pads is broken when the material of link 15 is melted. The combination of a Cr pad 26 having a diameter of 50-150 $\mu$m, a Cr pad 27 having a diameter of 30 $\mu$m, a polyimide insulator space between pads 26 and 27 of 100 $\mu$m, and a solder link 15 having a volume of approximately 25x 25x 100 $\mu$m$^3$ works well.

As discussed in the Background section above, ESD circuits are necessary at all MOS IC input ports that are not connected to a low impedance point and thus vulnerable to applied charges. That means all input ports of the IC (if the IC is not connected to some other circuit component or another IC) and all enabling test points must include ESD circuitry. In an effort to improve speed, reduce cost and reduce size, designers typically try to create MOS ICs that contain as much circuitry as possible. Some designs achieve this end by interconnecting a number of chips within a single package, sometimes called Multi Chip Module (MCM). More specifically, MOS IC chips are first manufactured, individually tested, and then interconnected within a single packaging arrangement. The interconnection may be with individual wires bonded between an output pad of one chip and an input pad of another chip, or it may be with a "prewired" chip carrier to which the chips are precisely attached. In the process of attachment to such a "prewired" chip carrier, all of the I/O ports of the MOS chip are simultaneously attached to signal paths of the chip carrier, thereby effectuating the interconnection between the attached MOS chips.

One method that uses this approach is sometimes referred to as "flip-chip" technology. See "Microelectronics Packaging Handbook", edited by Tummala et al., Van Nostrand Reinhold, 1989, Chapter 6. The carrier is substrate that includes insulated signal paths and accessible pads. The pads are positioned on the substrate to mate with pads of an MOS chip. The MOS chip is manufactured with accessible pads and solder beads on those pads. The MOS chips are placed on the carrier substrate (upside down, to effect the aforementioned mating of pads) and sent to an oven. The oven melts the solder beads which permanently attaches the MOS chip to the carrier. Of course, during testing and packaging prior to insertion of the board into the wave soldering machine the IC input pads are vulnerable to electrostatic damage.

When employing "flip-chip" technology to interconnect a number of MOS IC chips within a single IC carrier, the ESD circuits at inputs of chips that are not accessible at the I/O ports of the IC carrier serve no purpose, other than testing prior to interconnection. It follows that the operational speed of the circuit constructed on the IC carrier can be enhanced by including in the MOS chips breakable links in accordance with the principles of this invention; which links can be broken **after** the testing and flip-chip assembly phases. Any type of breakable link would serve the purpose of this invention, but the breakable link described above is particularly well suited because it does not require a large amount of energy to break the link, because the energy need not be concentrated and precisely delivered, and because in the "flip-chip" technology (and similar technologies) the energy for breaking the links is a natural by-product of the flip-chip assembly process.

The above describes a particular embodiment of a breakable link and a particular use for that link. Modifications to the link are, of course, possible without departing from the spirit and scope of this invention, as well as other uses for the link. For example, the material of layer 15 does not have to be solder and does not have to have a melting temperature that is substantially lower than that of the material making up layer 25 and pads 26 and 27. The reason is that the application of heat is a relatively slow process and one can heat up layer 15 and melt that material before the material below it also melts or changes its intended characteristics. Also, although the breakable link of this invention was described above in connection with ESD circuits, it should be clear that this breakable link is useful in other applications. Such applications may be for breaking entire sets of links, indiscriminately, or it may be for selective breaking of links with directed energy beams, such as lasers. One advantage of the breakable links of this invention even in applications of selective breaking of links is that the links of this invention are not *evaporated* by the energy source (which leaves a question as to where the evaporated electrically conducting materials have gone) but rather *repositions* the material.

**Claims**

1. A breakable connection on a substrate comprising:

    a first electrically conductive pad (11) connected to an electrically conductive path of said substrate,

    a second electrically conductive pad (12) connected to another electrically conductive path of said substrate;

    an electrically insulating region (25) between said first pad and said second pad,

    an electrically conducting layer segment ( 15) covering at least a portion of said said pad and at least a portion of said second pad, forming a breakable link,

    where said breakable link is formed of a material that possesses a lower surface energy than the surface energy of the material forming said first and second pad and a higher surface energy than the surface energy of the material forming said insulation region.

2. The breakable connection of claim 1 further comprising a first pad extension region associated with said first pad and a second pad extension region associated with said second pad that is physically separated from said first pad extension region, where the material forming said breakable link poassesses a lower surface energy than the surface energy of the material forming said first pad extension region and said second pad extension region.

3. The breakable connection of claim 1 where said first pad and said second pad are formed of a material that has a substantially higher melting point than the melting point of the material forming said breakable link.

4. The breakable connection of claim 1 where said breakable link is meltable with disfused heat energy.

5. An integrated circuit including active components manufactured therein comprising:

    a first access pad,

    a second access pad coupled to at least one of said active components,

    an intermediate pad,

    electrostatic discharge circuitry interposed between said first access pad and said intermediate pad, and

    a breakable link between said intermediate pad and said second access pad.

6. An IC circuit having a circuit of interconnected electronic components manufactured therein and having one or more test pads, with each test pad adapted for testing a selected point of said circuit through a conductive path, characterized in that:

    said path further includes a breakable link interposed between said test pad and said selected point in said circuit.

7. The IC of claim 6 further comprising electrostatic discharge circuitry interposed between said test pad and said breakable link.

8. The integrated circuit of claim 7 wherein said breakable link comprises:

    a first pad connected to said selected point,

    a second pad connected to said discharge circuitry,

    an insulating layer on said surface spanning a selected region of said surface between said first pad and said second pad,

    an electrically conducting layer segment over at least a portion of said insulating surface and covering at least a portion of said first pad and said second pad, forming a breakable link,

    where said first pad and said second pad are formed from a material that has a higher melting point than the material of said breakable link.

9. An IC assembly having a plurality of IC chips fastened to a carrier, where each of the IC chips includes a circuit having circuit components, input ports and output ports connected to the circuit, where at least some of the input ports comprise:

    a first access pad,

    a second access pad coupled to at least one of said circuit components,

    an intermediate pad,

    electrostatic discharge circuitry interposed between said first access pad and a first intermediate pad, and

    a breakable link between said intermediate pad and said second access pad.

10. An IC assembly having a plurality of IC chips fastened to a carrier, where each of the IC chips includes a circuit having circuit components, input ports and output ports connected to the circuit

where at least some of the input ports comprise;

a first pad,

a second pad connected to said circuit;

an electrically insulating region between said first pad and said second pad,

an electrically conducting layer segment covering at least a portion of said first pad and at least a portion of said second pad to form a conductive breakable link between said first pad and said second pad.

11. A flip-chip IC assembly including a plurality of IC chips fastened to a carrier having a pattern of conducting paths,

where each of the IC chips includes a circuit having circuit components, input ports and output ports connected to the circuit;

where at least some of the input ports comprise

a first access pad,

a second access pad coupled to at least one of said active components,

an intermediate pad, and

electrostatic discharge circuitry interposed between said first access pad and a first intermediate pad; and

where said conducting paths of said carrier connect to at least to some of said second access pads.

12. A method for assembling an IC, comprising the steps of:

obtaining an IC chip that includes

a circuit,

input ports

output ports,

a test pad,

a first pad, electrostatic discharge circuitry interconnecting said test pad and said first pad

a second pad connected to said circuit,

an electrically insulating region between said first pad and said second pad,

an electrically conducting layer segment covering at least a portion of said first pad and at least a portion of said second pad to form a conductive breakable link between said first pad and said second pad,

where the material of said breakable link has a lower surface energy than the surface energy of the material forming said first pad and said second pad and a higher surface energy than the surface energy of the material forming said insulating region,

testing the integrity of said IC chip by applying test signals to the test pads of at least some of said I/O ports;

when said step of testing verifies the integrity of said IC chip, installing said IC chip in said IC and removing the material of said breakable link from at least a portion of said electrically insulating region between said first pad and said second pad to disable conduction of current through said breakable link.

13. The method of claim 12 where said removing of said material of said breakable link from said electrically insulating region between said first pad and said second pad is accomplished by melting the material of said breakable link.

14. An arrangement having a surface, a region of a first material on said surface, a region of a second material on said surface, a third material positioned over at least a portion of said first region and over at least over a portion of said second region, characterized in that:

said third material is moved away from the region of said second material by the application of externally supplied heat.

15. The arrangement of claim 14 wherein said third material, when moved by the application of externally supplied heat, is contained within the region over which it was positioned prior to said application of the heat.

FIG. 1

FIG. 2

FIG. 3

FIG. 4

20

FIG. 5

SOAPY WATER

MERCURY

GLASS